# EUROPEAN PATENT SPECIFICATION

(11) **EP 0 568 144 B1**
(45) Date of publication and mention of the grant of the patent: **05.03.1997**
(21) Application number: 93201155.4
(22) Date of filing: 21.04.1993
(51) Int. Cl.: H01L 29/43, H01L 21/285

(54) **Semiconductor device with a semiconductor body of which a surface is provided with a barrier layer of TixW1-x, and method of manufacturing this device**
Halbleiteranordnung mit einem Halbleiterkörper, wobei eine Oberfläche des Halbleiterkörpers mit einer Barrierschicht aus TixW1-x versehen ist, und Verfahren zur Herstellung dieser Anordnung
Dispositif semiconducteur comportant un corps semiconducteur ayant une surface recouverte d'une couche de barrière de TixW1-x et procédé de fabrication de ce dispositif

(30) Priority: 28.04.1992 EP 92201178
(43) Date of publication of application: 03.11.1993
(73) Proprietor: Philips Electronics N.V., 5621 BA Eindhoven (NL)
(72) Inventor: Wolters, Robertus A.M., c/o INT. OCTROOIBUREAU BV, NL-5656 AA Eindhoven (NL); Swart, Edwin T., c/o INT. OCTROOIBUREAU BV, NL-5656 AA Eindhoven (NL); Dirks, Albertus G., c/o INT. OCTROOIBUREAU BV, NL-5656 AA Eindhoven (NL)
(74) Representative: Rensen, Jan Geert

(56) References cited:
- SOLID STATE TECHNOLOGY vol. 34, no. 5 , May 1991 , WASHINGTON US pages 97 - 102 D.PRAMANIK ET AL. 'BARRIER METALS FOR ULSI: PROCESSING AND RELIABILITY'
- THIN SOLID FILMS vol. 96 , 1982 , LAUSANNE,CH pages 327 - 345 C.Y.TING ET AL. 'THE USE OF TITANIUM-BASED CONTACT BARRIER LAYERS IN SILICON TECHNOLOGY'
- THIN SOLID FILMS vol. 96 , 1982 , LAUSANNE,CH pages 327 - 345 C.Y.TING ET AL.
- 'THE USE OF TITANIUM-BASED CONTACT BARRIER LAYERS IN SILICON TECHNOLOGY'

## Description

The invention relates to a semiconductor device with a semiconductor body of which a surface is provided with a barrier layer of TiₓW₁₋ₓ, with 0,1 < x < 0,3. The invention also relates to a method of manufacturing such a semiconductor device.

A barrier layer of TiₓW₁₋ₓ is used in the manufacture of semiconductor devices, for example, between contact zones of silicon or metal silicides provided in the semiconductor body and aluminium conductor tracks provided on the surface with the object of preventing chemical reactions between silicon and aluminium. These reactions could occur during the subsequent manufacture of the semiconductor device during which the semiconductor body is heated to a comparatively high temperature several more times.

A barrier layer of TiₓW₁₋ₓ is found in practice not to form an absolute barrier. Ti and W from the layer form chemical compounds with aluminium. Although the compounds with tungsten are formed less readily than those with titanium, so that in fact a layer without titanium would be preferable, in practice nevertheless 10 to 30 at. % titanium is added to the layer. This is done to ensure that the layer adheres well to the subjacent substrate and to ensure that the layer forms a low-ohmic contact with the subjacent silicon or metal silicide. It is also done, however, to ensure that the layer can be deposited by means of a practical sputtering deposition process.

In a sputtering deposition process, a slice of semiconductor material is positioned in a reaction chamber opposite to a target of the material to be deposited, upon which a plasma is generated in the vicinity of the target. Ions from the plasma hit the target and detach atoms from it, part of which atoms reach the slice and form a layer there. In a later stage of manufacture of the semiconductor device, the slice is subdivided into a number of separate semiconductor bodies. The atoms detached from the target do not only end up on the slice during the sputtering deposition process, but also on the walls of the reactor chamber. So a layer is deposited also on these walls. When the process is repeated, layers being deposited on other slices, the layer on the walls increases in thickness. If pure tungsten is deposited, a layer with bad adhesion is formed on the walls. Once the pure tungsten layer has reached a thickness of approximately 20 µm on the walls, tungsten particles will flake off from this layer and may end up on the surface of the semiconductor body. Such particles are not desired there. The reaction chamber, accordingly, must be cleaned before the layer on the walls has reached this critical thickness. The addition of 10 to 30% titanium to the layer achieves that the layer on the reaction chamber walls has a much better adhesion and does not start flaking off in practice until after it has reached a thickness of approximately 300 µm. This means that the reaction chamber need not be cleaned so often, which is of great practical advantage.

US-PS 5,019,234 discloses a semiconductor device of the kind mentioned in the opening paragraph in which a barrier layer of TiₓW₁₋ₓ is used with barrier properties which are improved in that the layer is exposed to the air for some time before a layer of aluminium is deposited on it. It is achieved in this way that the layer reacts less readily with the aluminium lying over it.

The use of the known barrier layer has the disadvantage that, if the exposure to air of the barrier layer is to provide a practical improvement of the barrier properties, this exposure must last for some days. This means that the manufacturing process of the semiconductor device is in fact delayed by that same number of days. In addition, exposure to air has the disadvantage that deposition of the barrier layer and of the layer of aluminium to be deposited thereon cannot be carried out in a modern multiple-chamber deposition device. In such a device, a semiconductor slice is transported from one deposition chamber to the other at low pressure, a layer being deposited in each chamber. Sometimes an additional etching treatment is carried out in an extra chamber. In such a device, for example, the surface of the slice may then first be cleaned by etching, then a TiₓW₁₋ₓ barrier layer may be deposited, and finally a aluminium layer may be deposited without the vacuum in the device being broken.

The invention has for its object *inter alia* to counteract the said disadvantages. According to the invention, the semiconductor device of the kind mentioned in the opening paragraph is for this purpose characterized in that the distance between the (100) lattice faces of W is greater than 2,25 Å (10Å=1nm) in the barrier layer.

It is found that such a barrier layer has equally good or even better barrier properties as than a layer which has been exposed to air for a few days.

This was demonstrated by means of tests in which a barrier layer of TiₓW₁₋ₓ and a layer of aluminium were deposited in that order on different silicon slices provided with a layer of silicon oxide in a multiple-chamber deposition device as described above. The layers were deposited under different sputtering conditions. The two layers were provided on some slices without these slices being taken from the deposition device, whereas other slices were taken from the deposition device between the depositions of the two layers and were exposed to air for a few days. Barrier layers were thus investigated during the tests which had not been exposed to air before deposition of the aluminium layer and which had, during the tests, the silicon slices provided with the barrier layer and the aluminium layer were heated in vacuum to a temperature of 450° C for some time. The electrical square resistance of the aluminium layer was measured during this. Since chemical compounds arising from reactions between titanium and tungsten from the barrier layer and aluminium have a resistance which is much greater than that of aluminium, the measured resistance increases in proportion as aluminium is converted into these compounds. It is obviously desirable for as little as possible aluminium to be converted. It was found in these tests that the sputtering conditions can be so chosen that less aluminium is converted in the said reactions in the case of a barrier layer not exposed to air than in the case of a barrier layer which had been exposed to air. The sputtering conditions must be so chosen in this case that the distance between the (100) lattice faces of W is greater than 2,25 Å in the barrier layer.

Preferably, the deposition conditions are so chosen that the distance between the (100) lattice faces of W is greater than 2,25 Å but smaller than 2,27 Å in the barrier layer. In that case the conversion of aluminium with the use of a barrier layer not exposed to air during the said tests is not only smaller than with the use of a barrier layer exposed to air, but it has in addition a minimum value.

A semiconductor device with a semiconductor body of which a surface is provided with a barrier layer of TiₓW₁₋ₓ, with 0,1 < x < 0,3, may be manufactured in a simple manner by means of a method in which a slice of semiconductor material is arranged in a reaction chamber parallel to a plane Ti_{y}W_{1-y} target, with 0,1 < y < 0,3, and to a plane conductive ring surrounding the target, after which argon is conducted into the reaction chamber and such a voltage is applied between the target and the conductive ring that a plasma is generated which is confined between the target and the slice and in a space close to the target by means of magnets positioned behind the target.

The layer thus deposited on the surface of the semiconductor body in practice has a composition which slightly deviates from that of the target. A fraction x of titanium is present in the deposited layer, whereas this is a fraction y in the target. It is found in practice that x is slightly smaller than y.

According to the invention, this method is characterized in that such a voltage is applied between target and conductive ring during deposition that a barrier layer is formed in which the distance between the (100) lattice faces of W is greater than 2,25 Å. It was surprisingly found that there is a relation between the voltage at the target and the said lattice distance, so that it is possible to control the deposition process in such a manner that a layer with the desired lattice distance is deposited. To ensure that the distance between the (100) lattice faces of W is greater than 2,25 Å, according to the invention, a voltage higher than 400 V is applied between the target and the conductive ring surrounding the target during deposition. The layer thus formed exhibits equally good or even better barrier properties as/than a layer which has been exposed to air for a few days.

Preferably, such a voltage is applied between the target and the conductive ring surrounding the target during deposition that a barrier layer is formed in which the distance between the (100) lattice faces of W is greater than 2,25 Å but smaller than 2,27 Å. In that case, according to the invention, a voltage is applied between the target and the conductive ring surrounding the target during deposition which is higher than 400 V and lower than 550 V. A layer is then formed whose barrier properties are not only better than those of a barrier layer exposed to air, but in addition have a optimum value.

The invention will be explained in more detail below by way of example with reference to a drawing and a few embodiments. In the drawing,
Figs. 1 to 3 diagrammatically and in cross-section show a few stages in the manufacture of the semiconductor device according to the invention,
Fig. 4 diagrammatically shows a multiple-chamber deposition device for carrying out the method according to the invention,
Fig. 5 diagrammatically shows one of the reaction chambers of the device according to Fig. 4,
Fig. 6 shows the lattice distance between tungsten (100) faces in the deposited barrier layer,
Fig. 7 shows the power dissipated in the plasma as a function of the voltage at the target in the chamber of Fig. 7 for a few argon pressures in the reaction chamber,
Fig. 8 shows the consumption C in nm of the aluminium layer as a function of time in minutes during heating at 450° C, and
Figs. 9, 10 and 11 show the consumption C of aluminium during heating at 450° C after 20, 30 and 40 or more minutes, respectively, as a function of the distance between the tungsten (100) lattice faces on slices on which the barrier layer had not been exposed to air and had been exposed to air for 60 minutes and 2800 minutes before the aluminium layer was deposited.

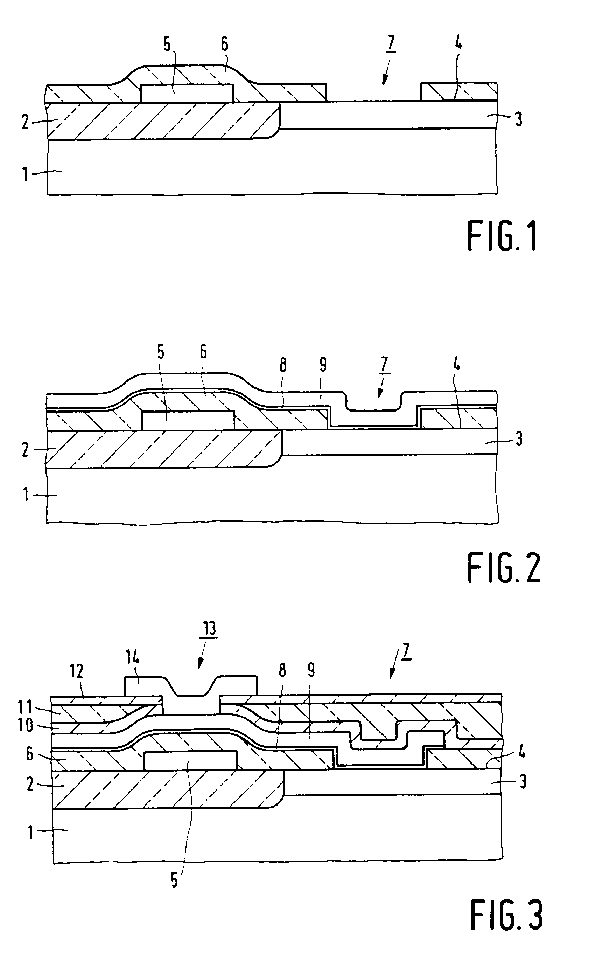

Figs. 1 to 3 diagrammatically and in cross-section show a few stages in the manufacture of a semiconductor device with a semiconductor body 1 of which a surface 4 is provided with a barrier layer 8 of TiₓW₁₋ₓ, with 0,1 < x < 0,3. The semiconductor body 1, for example, is an n-type doped semiconductor body 1 of silicon in which field oxide regions 2 and p-type doped semiconductor zones 3 are provided in usual manner, adjoining the surface 4. Conductor tracks 5 of polycrystalline silicon are provided on the surface 4 and are covered with an insulating layer 6 of silicon oxide. Windows 7 are provided in the insulating layer 6 for contacting the semiconductor zones 3. After that, a approximately 100 nm thick barrier layer of TiₓW₁₋ₓ, with 0,1 < x < 0,3, is provided on the surface 4, and on top of that an approximately 500 nm thick layer of aluminium 9. Up to a few percents of silicon and copper may be added to this layer 9. The semiconductor zones may also be provided with a top layer of a metal silicide in usual manner before the barrier layer 8 is deposited.

After the layers TiₓW₁₋ₓ 8 and aluminium 9 have been etched into a pattern in usual manner, a package of insulating layers 10, 11, 12 is provided in that order. A layer of silicon oxide 10 is deposited in a plasma deposition process (PECVD), a layer of spin-on glass (SOG) 11 is deposited by means of a spin-on method, and then a layer of silicon oxide 12 is provided in a plasma deposition process (PECVD) again. Contact windows 13 are provided in the layer package 10, 11, 12, so that a conductor pattern 14 provided on the package makes contact with the aluminium layer 9. The upper silicon oxide layer 12 is comparatively plane because the use of the layer of spin-on glass 11 in the layer package 10, 11, 12 has a smoothing effect.

The barrier layer 8 of TiₓW₁₋ₓ is used in the manufacture of semiconductor devices to ensure that the aluminium layer 9 adheres well to the silicon oxide layer 6 and to counteract chemical reactions between the silicon of semiconductor zones 3 provided in the semiconductor body 1 and made of silicon or metal silicides and the aluminium of the conductor tracks 9 provided on the surface. These reactions could occur during subsequent manufacturing steps of the semiconductor device during which the semiconductor body is heated to comparatively high temperatures several more times. During deposition of the silicon oxide layer 10, the semiconductor body 1 is heated for approximately 10 minutes at 300° C, after the deposition of the spin-on glass layer 11 for approximately 40 minutes at 425° C for densifying the layer, and again for approximately 10 minutes at 300° C during deposition of the silicon oxide layer 12. After the conductor pattern 14 has been provided, during which the semiconductor body 1 reaches a temperature of approximately 200° C, a layer of silicon oxide and a layer of silicon nitride are also deposited. During these deposition processes, the semiconductor body is at a temperature of 300° C for approximately 30 minutes. Finally, a final heat treatment is carried out for approximately 20 minutes at a temperature of 425° C. Aluminium practically does not react with Ti and W from the barrier layer 8 during heat treatments at a temperature of 300° C or lower, this happens mainly during the treatments at temperatures above 400° C. Of practical importance in view of the said chemical reactions are only the heat treatments above 400° C, in this example a total of 60 minutes at a temperature of 425°C.

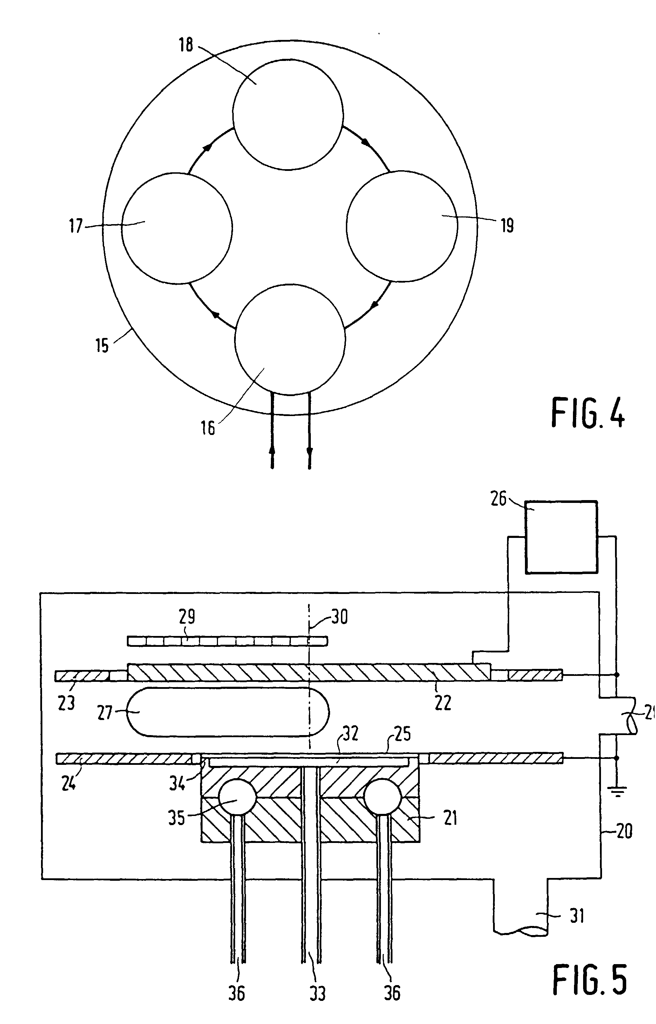

Fig. 4 diagrammatically shows a multiple-chamber deposition device for carrying out the method according to the invention. This device comprises a vacuumtight housing 15 within which four chambers 16, 17, 18, 19 are arranged in this example. Inside the housing 20, semiconductor slices may be transported from one chamber to the next under vacuum, as is diagrammatically indicated with arrows. Through a first chamber 16 - the load lock - the semiconductor slices can be put into and taken from the housing. In the second chamber 17, for example, the slices are subjected to a usual sputter etching treatment for cleaning the slice surface. The barrier layer 8 is deposited in the third chamber 18 and the aluminium layer 9 in the fourth chamber 19. Finally, the slices are taken from the housing through the first chamber 16 again. The slices then comprise a large number of semiconductor devices in a stage of manufacture as shown in Fig. 2. In a later stage of manufacture of the semiconductor device, the slices are subdivided into a number of separate semiconductor bodies 1.

Fig. 5 diagrammatically shows one of the deposition chambers of the multiple-chamber deposition device. A support 21 is arranged in the reaction chamber 20 parallel to a plane target 22 and to a plane earthed conductive ring 23 surrounding the target 22. An earthed screen 24 is provided around the support. A slice of semiconductor material 25 is placed on the support 21, after which argon is introduced into the reaction chamber. A usual DC voltage source 26 is connected between the target 22 and the conductive ring 23 surrounding the target 22, so that a voltage of between 300 and 700 V generates a plasma which is kept confined between the target 22 and the slice 25 and in a space 27 close to the target 22 by magnets 29 arranged behind the target. The argon is introduced into the reaction chamber through a gas inlet 28.

The magnets 29 are jointly rotatable about a axis 30. In practice, they rotate a few times every second about the axis 30 during the deposition process, so that the plasma and the space 27 in which it is confined are rotated about the same axis 30. It is achieved by this that atoms are sputtered homogeneously from the entire surface of the target 22 and that a homogeneous deposition over the entire slice 25 is obtained.

The slice 25 was cooled during deposition in that a gas cushion 32 with a pressure of 100 to 2000 Pa was maintained between the support 21 and the semiconductor slice 25. Argon is conducted between the support 21 and the slice 25 through a gas line 33. The support 21 is provided with an edge 34 against which the slice 25 is pressed by clamps (not shown). Argon leakage from the gas cushion 32 into the reactor chamber 20 is restricted by this. The support 21 is cooled in that cooling water is conducted through lines 36 into a channel 35 provided in the support 21.

The chamber 20 is further provided with a gas outlet 31 which is connected to a pump (not shown) by which gases can be removed and by which the reaction chamber 20 can be kept at a desired pressure.

In the tests to be described below, and in a multiple-chamber deposition device described above, a 100 nm thick barrier layer of TiₓW₁₋ₓ and a usual 500 nm thick aluminium layer comprising 1 vol.% silicon were deposited in that order on several silicon slices provided with a layer of silicon oxide. The layers were deposited under different sputtering conditions by means of a sputtering target of Ti_{y}W_{1-y} with y = 0,3. The two layers were provided on some slices without the slices being taken from the deposition device, whereas other slices were taken from the deposition device between the deposition operations of the two layers and exposed to air for one hour or several days. Barrier layers were thus investigated during the tests which had not been exposed to air before deposition of the aluminium layer and barrier layers which had.

Silicon slices provided with the barrier layer and the aluminium layer were heated in vacuum for some time at a temperature of 450° C. The electrical square resistance of the aluminium layer was measured during this. Since chemical compounds generated by reactions between titanium and tungsten from the barrier layer and aluminium have a resistance which is much greater than that of aluminium, the measured resistance increases as aluminium is converted into these compounds. It was calculated from the increase of this resistance how much aluminium was consumed for the conversion into one of the said compounds. The aluminium layer becomes as it were thinner. This thickness reduction is given as a measure for the quantity of aluminium consumed in the following test results.

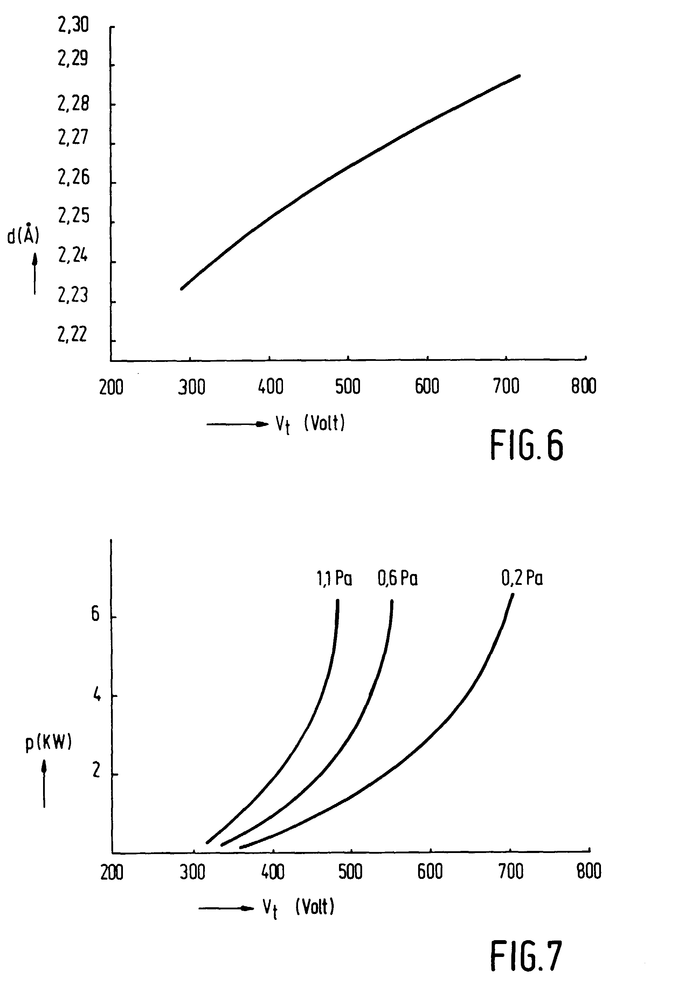

The distance between (100) lattice faces of tungsten was also measured for the deposited barrier layers by means of X-ray diffraction. Fig. 6 shows this lattice distance d in Å as a function of the voltage Vₜ applied between the target 22 and the conductive ring 23 surrounding the target. The target 22 had a diameter of 26 cm in the tests. The conductive ring 23 had an internal diameter of 26,5 cm and an external diameter of 30 cm. The slices had a diameter of 15 cm. The slices were cooled during the tests so that their temperatures did not rise above 200° C.

As is apparent from Fig. 7, which shows the power P in kW dissipated in the reaction chamber 20 as a function of the voltage Vₜ between the target 22 and the conductive ring 23 for some pressures (0,3, 1 and 2 Pa) of the argon in the reaction chamber 20, this voltage Vₜ may be realised in various ways.

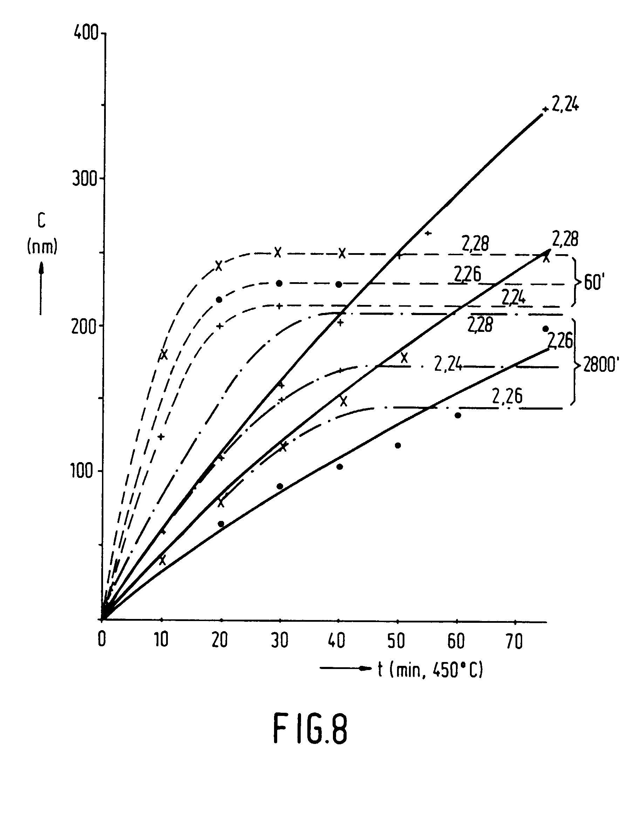

Fig. 8 shows the consumption C in nm of the aluminium layer as a function of time in minutes during vacuum heating at 450° C. The drawn lines show the consumption on slices on which the aluminium layer was directly deposited on the barrier layer, the broken lines show the consumption on slices on which the aluminium layer was deposited after the barrier layer had been exposed to air for 60 minutes, while the dash-dot lines show the consumption on slices on which the aluminium layer was deposited after the barrier layer had been exposed to air for 2 days. To keep the Figure simple, these consumptions are represented for three kinds of barrier layers only, *i.e*. layers with a distance between the (100) tungsten lattice faces of 2,24 Å, 2,26 Å and 2,28 Å.

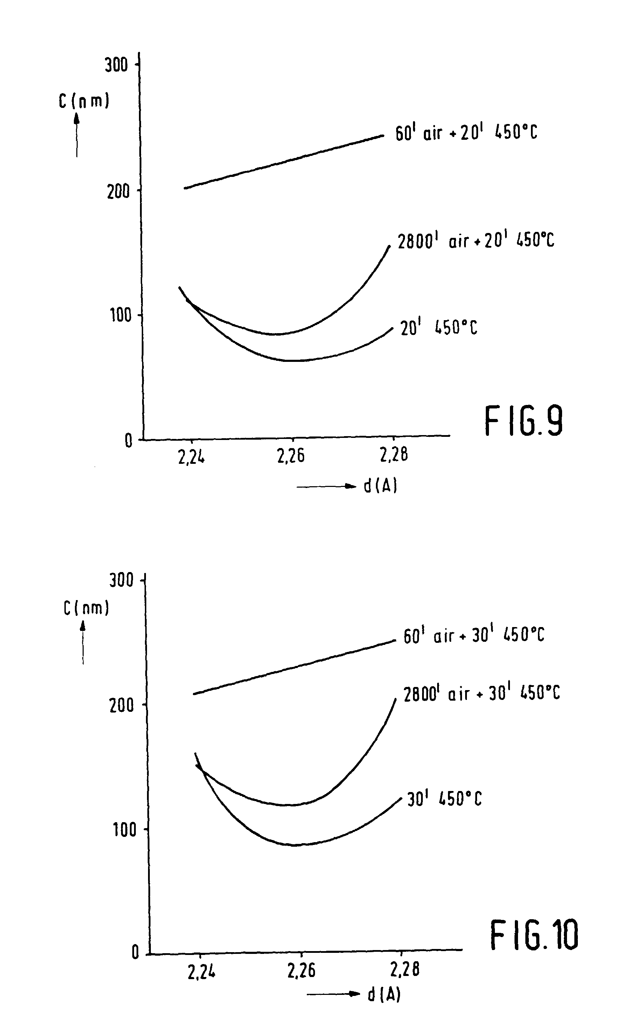

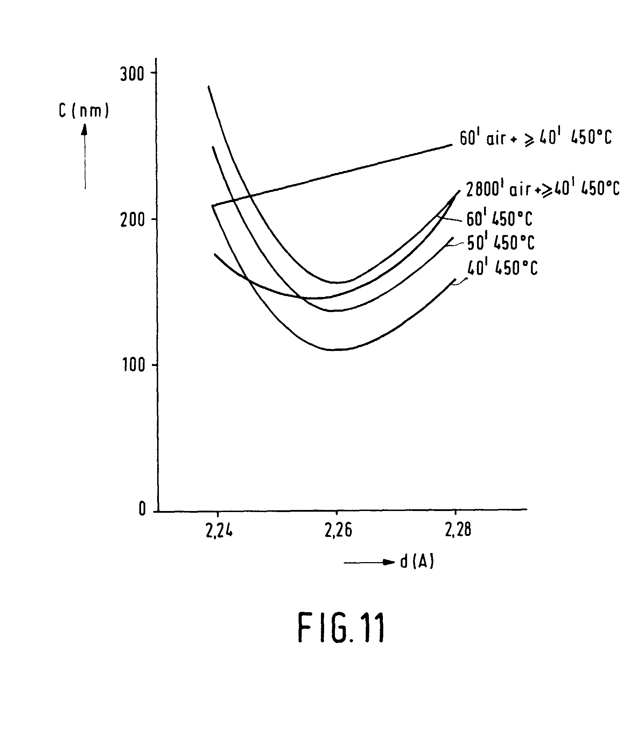

Figs. 9, 10 and 11 show the consumption of the aluminium layer as a function of the distance between the tungsten (100) lattice surfaces d in Å on slices on which the barrier layer had not been exposed to air, had been exposed for 60 minutes and had been exposed for 2 days (= 2800 minutes) to air before the aluminium layer was deposited. Fig. 9 shows the consumption figures after 20 minutes of heating in vacuum at 450° C, Fig. 10 after 30 minutes and Fig. 11 after 40, 50 and 60 minutes. In the case shown in Fig. 11, there was no discernible difference in consumption after 40, 50 and 60 minutes heating at 450° C of aluminium deposited on the barrier layers exposed to air.

In practice, semiconductor slices are subjected to heat treatments which cause less aluminium consumption during further process steps, after the deposition of the TiₓW₁₋ₓ barrier layer 8 and the aluminium layer 9, than the heat treatment carried out during the tests. During the manufacture of the semiconductor device described above (Figs. 1 to 3), for example, the slice was heated for a total of 60 minutes at a temperature of 425° C. A heat treatment of 60 minutes at 425° causes an aluminium consumption which is much less - in practice approximately one third - than the aluminium consumption caused by a heat treatment of 60 minutes at a temperature of 450° C. Conductor patterns 8 and 14 were formed in two layers in the semiconductor device described above. No heat treatments are used in practice in such a modern "double-metal process" which cause a greater aluminium consumption than a heat treatment of 60 minutes at 450° C.

It is evident from Figs. 9, 10 and 11 that a barrier layer of TiₓW₁₋ₓ with x = 0,3 in which the distance between the (100) tungsten lattice faces is greater than 2,25 Å causes less aluminium consumption, and accordingly has equally good or even better barrier properties as/than a TiₓW₁₋ₓ barrier layer which has been exposed to air for a few days. If the distance between the (100) lattice faces of W is greater than 2,25 Å but smaller than 2,27 Å in the barrier layer, the aluminium consumption in a barrier layer not exposed to air is not only smaller than that in a barrier layer exposed to air, but in addition has a minimum value.

Fig. 6 shows that the barrier layer according to the invention may be readily deposited by means of the deposition device described above (Figs. 4 and 5). To manufacture the semiconductor device with the semiconductor body 1 whose surface 4 is provided with a barrier layer 8 of TiₓW₁₋ₓ, with 0,1 < x < 0,3, this barrier layer is deposited in the chamber 18 in that the slice 25 is placed on the support 21 in the reaction chamber 20 opposite a Ti_{y}W_{1-y} target, with 0,1 < y < 0,3. Then argon is conducted into the reaction chamber and a plasma is generated in the space 27. The voltage between the target 22 and the conductive ring 23 surrounding the target is kept at such a value during deposition that a barrier layer is formed in which the distance between the (100) lattice faces of W is greater than 2,25 Å.

Surprisingly, there is a relation between the voltage between the target 22 and the ring 23 on the one hand and the distance between the said lattice faces on the other hand, so that it is possible to control the deposition process in such a manner that a layer with the desired lattice distance is deposited. To ensure that the distance between the (100) lattice faces of W is greater than 2,25 Å, according to the invention, a voltage above 400 V is applied between the target 22 and the conductive ring 23 surrounding the target during the deposition. The layer formed in this manner exhibits the said equally good or even better barrier properties compared with a layer which has been exposed to air for a few days.

Preferably, such a voltage is applied between the target 22 and the conductive ring 23 surrounding the target during deposition that a barrier layer is formed in which the distance between the (100) lattice faces of W is greater than 2,25 Å but smaller than 2,27 Å. In that case, according to the invention, a voltage between the target 22 and the conductive ring 23 surrounding the target above 400 V and below 550 V is applied during the deposition. A layer is then formed whose barrier properties are not only better than those of a barrier layer exposed to air, but which in addition have an optimum value.

Fig. 7 shows that the voltage between the target 22 and the ring 23 surrounding the target may be realised in various ways. Preferably, the deposition process is so carried out that the barrier layer of approximately 100 nm thickness is deposited in approximately 10 to 30 seconds. It is found in practice that such a process is realised if argon is fed into the reaction chamber under a pressure of 0,6 to 1,2 Pa during the deposition, while a electric power of 3500 to 4500 W is supplied to the plasma.

The tests described above were carried out by means of a deposition process in which TiₓW₁₋ₓ barrier layers were deposited in a deposition device with a Ti_{y}W_{1-y} target, y being 0,3. It is noted that similar results were obtained with targets of a different composition, where 0,1 < y < 0,3. The TiₓW₁₋ₓ layers deposited always had a composition with 0,1 < x < 0,3. The composition of the barrier layer depends not only on the composition of the target used but also on the deposition conditions. Thus it was found that a layer deposited by means of a target with y = 0,3 and having distances between the (100) tungsten lattice faces of 2,24 Å, 2,26 Å, and 2,28 Å, the fractions x were 0,28, 0,23 and 0,21, respectively.

## Claims

1. A semiconductor device with a semiconductor body of which a surface is provided with a barrier layer of TiₓW₁₋ₓ, with 0,1 < x < 0,3, characterized in that the distance between the (100) lattice faces of W is greater than 0,225 nm (2,25 Å) in the barrier layer.

2. A semiconductor device as claimed in Claim 1, characterized in that the distance between the (100) lattice faces of W is greater than 0,225 nm (2,25 Å) but smaller than 0,227 nm (2,27 Å) in the barrier layer.

3. A method of manufacturing a semiconductor device with a semiconductor body of which a surface is provided with a barrier layer of TiₓW₁₋ₓ, with 0,1 < x < 0,3, whereby a slice of semiconductor material is arranged in a reaction chamber parallel to a plane Ti_{y}W_{1-y} target, with 0,1 < y < 0,3, and to a plane conductive ring surrounding the target, after which argon is conducted into the reaction chamber and such a voltage is applied between the target and the conductive ring that a plasma is generated which is confined between the target and the slice and in a space close to the target by means of magnets positioned behind the target, characterized in that such a voltage is applied between target and conductive ring during deposition that a barrier layer is formed in which the distance between the (100) lattice faces of W is greater than 0,225 nm (2,25 Å).

4. A method as claimed in Claim 3, characterized in that such a voltage is applied between the target and the conductive ring surrounding the target during deposition that a barrier layer is formed in which the distance between the (100) lattice faces of W is greater than 0,225 nm (2,25 Å) but smaller than 0,227nm (2,27 Å).

5. A method as claimed in Claim 3, characterized in that a voltage higher than 400 V is applied between the target and the conductive ring surrounding the target during deposition.

6. A method as claimed in Claim 4, characterized in that a voltage is applied between the target and the conductive ring surrounding the target during deposition which is higher than 400 V and lower than 550 V.

7. A method as claimed in Claim 5 or 6, characterized in that argon is fed into the reaction chamber under a pressure of 0,6 to 1,2 Pa during the deposition, while an electric power of 3500 to 4500 W is supplied to the plasma.

## Patentansprüche

1. Halbleiteranordnung mit einem Halbleiterkörper, von dem eine Oberfläche mit einer Barriereschicht aus TiₓW₁₋ₓ versehen ist, mit 0,1 < x < 0,3, dadurch gekennzeichnet, daß der Abstand zwischen den (100)-Gitterebenen von W in der Barriereschicht größer ist als 0,225 nm (2,25 Å).

2. Halbleiteranordnung nach Anspruch 1, dadurch gekennzeichnet, daß der Abstand zwischen den (100)-Gitterebenen von W in der Barriereschicht größer als 0,225 nm (2,25 Å), aber kleiner als 0,227 nm (2,27 Å) ist.

3. Verfahren zur Herstellung einer Halbleiteranordnung mit einem Halbleiterkörper, von dem eine Oberfläche mit einer Barriereschicht aus TiₓW₁₋ₓ versehen ist, mit 0,1 < x < 0,3, wobei eine Halbleitermaterialscheibe in einer Reaktionskammer parallel zu einem ebenen Ti_{y}W_{1-y}-Target, mit 0,1 < y < 0,3, und einem das Target umgebenden ebenen leitenden Ring angeordnet wird, woraufhin Argon in die Reaktionskammer geleitet wird und zwischen dem Target und dem leitenden Ring eine solche Spannung angelegt wird, daß ein Plasma generiert wird, das zwischen dem Target und der Scheibe und in einem nahe dem Target liegenden Raum mit Hilfe von hinter dem Target plazierten Magneten eingeschlossen wird, dadurch gekennzeichnet, daß zwischen dem Target und dem leitenden Ring während der Abscheidung eine solche Spannung angelegt wird, daß eine Barriereschicht gebildet wird, in der der Abstand zwischen den (100)-Gitterebenen von W größer ist als 0,225 nm (2,25 Å).

4. Verfahren nach Anspruch 3, dadurch gekennzeichnet, daß zwischen dem Target und dem leitenden Ring während der Abscheidung eine solche Spannung angelegt wird, daß eine Barriereschicht gebildet wird, in der der Abstand zwischen den (100)-Gitterebenen von W größer ist als 0,225 nm (2,25 Å), aber kleiner als 0,227 nm (2,27 Å).

5. Verfahren nach Anspruch 3, dadurch gekennzeichnet, daß während der Abscheidung zwischen dem Target und dem das Target umgebenden leitenden Ring eine Spannung angelegt wird, die höher als 400 V ist.

6. Verfahren nach Anspruch 4, dadurch gekennzeichnet, daß während der Abscheidung zwischen dem Target und dem das Target umgebenden leitenden Ring eine Spannung angelegt wird, die höher als 400 V Rind niedriger als 550 V ist.

7. Verfahren nach Anspruch 5 oder 6 dadurch gekennzeichnet, daß während der Abscheidung Argon unter einem Druck von 0,6 bis 1,2 Pa in die Reaktionskammer eingeleitet wird, wobei dem Plasma eine elektrische Leistung von 3500 bis 4500 W zugeführt wird.

## Revendications

1. Dispositif semiconducteur présentant un corps semiconducteur dont une surface est munie d'une couche barrière de TiₓW₁₋ₓ, avec 0,1 < x < 0,3, caractérisé en ce que la distance comprise entre les faces de réseau (100) de W est supérieure à 0,225 nm (2,25 Å) dans la couche de barrière.

2. Dispositif semiconducteur selon la revendication 1, caractérisé en ce que la distance comprise entre les faces de réseau (100) de W est supérieure à 0,225 nm (2,25 Å), mais inférieure à 0,227 nm (2,27 Å) dans la couche de barrière.

3. Procédé pour la fabrication d'un dispositif semiconducteur présentant un corps semiconducteur dont une surface est munie d'une couche de barrière de TiₓW₁₋ₓ, avec 0,1 < x < 0,3, selon lequel une plaque de matériau semiconducteur est disposée dans une chambre de réaction parallèle à une cible plane de Ti_{y}W_{1-y}, avec 0,1 < y < 0,3 et à un anneau conducteur plan entourant la cible, après quoi de l'argon est introduit dans la chambre de réaction et une tension est appliquée entre la cible et l'anneau conducteur de façon à engendrer un plasma, qui est enfermé entre la cible et la plaque et dans un espace situé tout près de la cible à l'aide d'aimants positionnés derrière la cible, caractérisé en ce que, lors du dépôt, une tension est appliquée entre la cible et l'anneau conducteur de façon qu'il se forme une couche de barrière dans laquelle la distance est comprise entre les faces de réseau (100) de W est supérieure à 0,225 nm (2,25 Å).

4. Procédé selon la revendication 3, caractérisé en ce que, lors du dépôt, une tension est appliquée entre la cible et l'anneau conducteur d'une façon qu'il se forme une couche de barrière dans laquelle la distance comprise entre les faces de réseau (100) de W est supérieure à 0,225 nm (2,25 Å), mais inférieure à 0,227 nm (2,27 Å).

5. Procédé selon la revendication 3, caractérisé en ce que, lors du dépôt, une tension supérieure à 400 V est appliquée entre la cible et l'anneau entourant la cible.

6. Procédé selon la revendication 4, caractérisé en ce que, lors du dépôt, une tension supérieure à 400 V et inférieure à 550 V est appliquée entre la cible et l'anneau conducteur entourant la cible.

7. Procédé selon la revendication 5 ou 6, caractérisé en ce que, lors du dépôt, de l'argon est introduit dans la chambre de réaction sous une pression de 0,6 à 1,2 Pa, alors qu'une puissance électrique de 3500 à 4500 W est amenée au plasma.
